# EUROPEAN PATENT SPECIFICATION

(11) **EP 2 545 584 B1**
(45) Date of publication and mention of the grant of the patent: **26.06.2019**
(21) Application number: 11754019.5
(22) Date of filing: 09.03.2011
(51) Int. Cl.: H01L 23/433, H01L 23/495, H01L 23/28, H01L 23/31

(54) **PACKAGE HAVING SPACED APART HEAT SINK**
PAKET MIT IN EINEM ABSTAND ANGEORDNETEN KÜHLKÖRPER
ENROBAGE COMPORTANT UN DISSIPATEUR DE CHALEUR ESPACÉ

(30) Priority: 10.03.2010 US 721486
(43) Date of publication of application: 16.01.2013
(73) Proprietor: Altera Corporation, San Jose, CA (US)
(72) Inventor: LIM, Ken, Beng, San Jose CA 95134 (US); TOONG, Teik, Tiong, San Jose CA 95134 (US)
(74) Representative: Appelt, Christian W.
(86) International application number: PCT/US2011/027768
(87) International publication number: WO 2011/112728

(56) References cited:
- JP-A- H 088 384
- JP-A- H0 521 648
- JP-A- 10 242 347
- JP-A- H06 268 144
- JP-A- H09 172 126
- JP-A- 2005 033 123
- US-A- 5 053 855
- US-A- 5 698 899
- US-A- 5 750 423
- US-A- 5 973 407
- US-A1- 2001 002 067
- US-A1- 2006 289 971
- US-B1- 6 258 630

## Description

### BACKGROUND

Current wire bonding packages provide for a heat sink that is disposed, i.e., "dropped in," against a die paddle of the lead frame. In such a package there is no adhesion between the die paddle and the heat sink. However, the molding compound cannot penetrate the area between the die paddle and the heat sink in this configuration. The lack of molding compound in this area increases the thermal resistance of the package and creates internal stresses within the package due to expansion forces in the area between the die paddle and the heat sink. In addition, as the die size and die paddle size increase, these expansion forces create even more internal stress within the package. The constant exposure to these internal stresses can eventually cause delamination, which can lead to failure of the device.

US 5,973,407 discloses an integral heat spreader for semiconductor package which is a metal plate and characterized in that a plurality of upper bumps are provided on the top surface of the metal plate. By the provision of the upper bumps, one or more space(s) can be formed between the bottom surface of the paddle and the top surface of the heat spreader for the compact filling of molding compound. Therefore, the occurrence of gap or delamination can be prevented, while maintaining the necessary effect of heat dissipation.

US 5,053,855 relates to a semiconductor device that comprises a die pad having first and second surfaces; a semiconductor chip having a plurality of electrodes and mounted on the first surface of the die pad; a radiator attached by caulking to the second surface of the die pad; a plurality of leads each of which has one end electrically connected to a corresponding electrode of the chip; and a resin package in which the die pad, the semiconductor chip, the radiator and the ends of the leads are molded. This semiconductor device exhibits excellent thermal radiator properties.

US 2001/0002067 A1 provides a resin-encapsulated semiconductor device having inner leads and at least a heat spreader, wherein at least an electrical insulator is provided between the inner leads and the heat spreader, or wherein suspension pins for suspending an island mounting a semiconductor device are formed to have a lower level than the inner leads, or wherein the heat spreader has a fixing means for fixing the heat spreader over position, or wherein the heat spreader has an elevated center region having a light level than a peripheral region of the heat spreader.

JP H05-021648 provides a semiconductor device having improved heat dissipation using a method wherein molten sealing material is filled between an island and a heat dissipating thermal conductor without generating voids keeping a gap between the island and the heat dissipating thermal conductor constant against the injection pressure at molding. A semiconductor chip 1 is connected to inner leads 3a with metal fine wires 4. An island 2 where the semiconductor chip 1 is mounted and heat dissipating thermal conductors 5 are arranged at a small interval confronting each other. A sealing material 6 is made to cover all the body excluding outer leads 3b and cured. A bent protrusion 9 and an opening 8 are formed by cutting the heat dissipating conductor 5 at a main body 5a and erecting a cut part, and the erected protrusion 9 is made to bear against the island 2, whereby the gap between the heat dissipating conductor 5 and the island 2 can be kept constant against the injection pressure at the molding of the sealing material 6.

JP H08-008384 relates to another semiconductor device in which high hermetic sealing performance and heat dissipation performance can be ensured at low cost and a method for mass producing the semiconductor device without increasing the mounting step. A groove 4 and a protrusion 5 are provided at the island part 3 of a lead frame for fixing a semiconductor element 6 and at a lead 2 for connecting the semiconductor element 6 with a pad. The groove 4 at the island part 3 is filled with a material 8 for bonding the semiconductor element 6 and each protrusion 5 extends to the outside of a material 9 for sealing the semiconductor element 6. The protrusion 5 of the lead 2 being connected with a pad of the semiconductor element 6 and the protrusion 5 at the island part 3 for fixing the semiconductor element 6 extend in the direction perpendicular to the plane of the lead frame.

JP H06-268144 relates to another semiconductor integrated circuit device which realizes a long life by a method wherein a crack caused in the semiconductor integrated circuit device is reduced and a heat-dissipating effect is increased. The semiconductor integrated circuit device is provided with a structure by which a semiconductor element is fixed to tabs is formed of the tabs 7 to which a chip 6 as the semiconductor element is fixed and in which protrusion parts 7a as bonding means to a molding resin 10 are installed, of a lead frame 8 which transmits a signal from the chip 6 to external terminals, of wires 9 which connect the chip 6 to the lead frame 8 and of the molding resin 10 which seals the chip 6, the tabs 7 and the bonding wires 9.

US 5,750,423 provides lead frames with at least one supporting portion extending from an island thereof in the direction opposite to a surface on which a semiconductor chip is mounted, so that the supporting portion comes into contact with a bottom surface of a cavity of a mold for encapsulation of semiconductor chips with a resin when said mold is closed.

US 2006/0289971 A1 shows a semiconductor device comprising a lead frame, which has first and second surfaces, a planar pad of a certain size, and a plurality of non-coplanar members adjoining the pad. The device further has a heat spreader with first and second surfaces, a planar pad of a size matching the lead frame pad size, and contours, into which the lead frame members are inserted so that the first spreader pad surface touches the second lead frame pad surface across the pad size. A semiconductor chip is mounted on the first lead frame pad surface. Encapsulation material, preferably molding compound, covers the chip, but leaves the second spreader surface uncovered.

JP H09-172126 A prevents a heat sink from moving outside at the time of resin-sealing. This is achieved by a semiconductor chip which is bonded on the die pad of a lead frame with silver paste adhesive, and a heat sink is bonded between the protruding parts provided at the bottom of the die pad with adhesive. Then, the semiconductor chip and the lead of the lead frame are electrically connected by bonding wire, and the outer part is sealed by sealing resin. This structure permits a layer of the adhesive to receive sealing pressure even in the resin sealing process, and prevents the heat sink from flowing by the sealing resin even when the layer of the adhesive is removed from the die pad. Thus, the heat sink is prevented from removing from the bottom of the die pad, and resin-sealing is performed at the correct position.

### SUMMARY

The embodiments described herein provide a package for an integrated circuit having enhanced structural integrity. It should be appreciated that the present invention can be implemented in numerous ways, such as a process, an apparatus, a system, a device or a method. Several inventive embodiments of the present invention are described below.

In one aspect of the invention, an integrated circuit (IC) package that includes a lead frame and a die affixed to a first surface of a pad of the lead frame. The die is wire bonded to the lead frame. The package includes a heat sink spaced apart from a second surface of the pad, where the second surface opposes the first surface. Molding compound encapsulates the lead frame and the die. The molding compound is disposed between the heat sink and the second surface of the pad and is enabled access between the heat sink and the second surface through protruding features disposed on the heat sink and the second surface. The protruding features are responsible for the spaced apart configuration of the heat sink and the second surface.

In another aspect of the invention, a method of packaging a semiconductor device is provided. The method initiates with affixing a die to a first surface of a die pad of a lead frame. The method includes wire bonding bond pads of the die to leads extending from the lead frame and disposing a heat sink over a second surface of the die pad such that a surface of the heat sink is spaced apart from a portion of the second surface and the surface of the heat sink by protruding features disposed on the second surface, and the heat sink. Further, surface of the heat sink may contact a different portion of the second surface. The die and the lead frame are encapsulated with a molding compound such that the molding compound fills a cavity defined between the surface of the heat sink and the portion of the second surface. The disposal of the molding compound between the heat sink and the second surface provides for enhanced structural integrity of the package as the package is better able to resist internal stresses due to heat expansion forces experienced by the package. In addition, the molding compound functions as an adhesive for the die pad and the heat sink.

Other aspects of the invention will become apparent from the following detailed description, taken in conjunction with the accompanying drawings, illustrating by way of example the principles of the invention.

### BRIEF DESCRIPTION OF THE DRAWINGS

The present invention will be readily understood by the following detailed description in conjunction with the accompanying drawings, and like reference numerals designate like structural elements
Figure 1 is a simplified schematic diagram illustrating a lead frame in accordance with example implementation useful for understanding better the invention.
Figure 2 is a simplified schematic diagram illustrating a cross-sectional view of a package configuration for an integrated circuit in accordance with example implementation useful for understanding better the invention.
Figure 3 is a simplified schematic diagram illustrating a cross-sectional view of a package configuration for an integrated circuit in accordance with an alternate embodiment of the invention.
Figures 4A and 4B are simplified schematic diagrams illustrating alternate views of a lead frame having protruding features according to example implementation useful for understanding better the invention.
Figures 5A and 5B are simplified schematic diagrams illustrating alternate views of a lead frame having protruding features for an embodiment varied from the embodiment of Figures 4A and 4B.
Figure 6 is a simplified schematic diagram illustrating a package configuration having a centrally located offset on a die paddle surface in accordance with example implementation useful for understanding better the invention.
Figure 7 is a flowchart diagram illustrating the method operations of packaging a semiconductor device in accordance with one embodiment of the invention.

### DETAILED DESCRIPTION

The embodiments described herein provide a package architecture for an integrated circuit. It will be obvious, however, to one skilled in the art, that the present invention may be practiced without some or all of these specific details. In other instances, well known process operations have not been described in detail in order not to unnecessarily obscure the present invention.

The embodiments described herein provide for a package solution to address the internal stresses created through current wire bond packaging configurations with a dropped in heat sink. In the embodiments described below, a protruding feature either on the die paddle, the heat sink, or a combination of both, enables the molding compound to access the area between the die paddle surface and the heat sink surface. By filling the cavity created through the protruding feature with molding compound, the stresses on the package are better tolerated to provide for a lower failure rate.

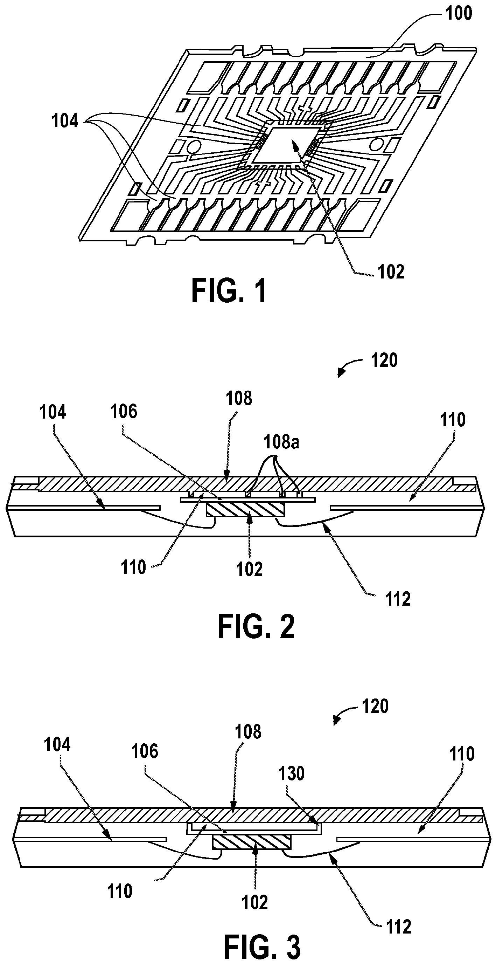

Figure 1 is a simplified schematic diagram illustrating a lead frame in accordance with one implementation for better understanding the invention. Lead frame 100 is illustrated in a top planar view for exemplary purposes. One skilled in the art will appreciate that lead frame 100 may be stamped so that leads 104 are oriented on a different plane than die paddle 102. As explained in more detail below die paddle 102 may include protruding features on a surface opposing a dropped in heat sink. In an alternative implementation the dropped in heat sink may include protruding features in order to be spaced apart from the opposing surface of die paddle 102. It should be appreciated that the implementations may include protruding features on both the surface of die paddle 102 and the heat sink. Accordingly, the implementations described herein that are not meant to be limiting as they are exemplary. In addition, numerous other lead frame configurations are capable of being implemented with the implementations described herein as Figure 1 is only one exemplary configuration that is not meant to be limiting.

Figure 2 is a simplified schematic diagram illustrating a cross-sectional view of a package configuration for an integrated circuit in accordance with one implementation for better understanding the invention. Package configuration 120 includes die 102 being wire bonded to leads 104 of the lead frame. The lead frame includes die paddle 106 which may or may not be connected to leads 104. Die 102 is wire bonded to leads 104 through wires 112. Heat sink 108 is disposed in an offset manner from die paddle 106. The heat sink 108 may be dropped into the package configuration in one example implementation. Mold compound 110 is utilized to encapsulate die 102 and the lead frame. In one implementation, mold compound 110 is provided through an injection molding process. Heat sink 108 includes protruding features 108a. Protruding features 108a extend from a surface of heat sink 108 opposing a surface of die paddle 106. In one implementation, protruding features 108a extend from the surface of heat sink 108 between about 0.0127 cm and about 0.0254 cm. Consequently, a gap or cavity is created between a surface of heat sink 108 and die paddle 106. Thus, as the mold compound 110 is injected into the package, the mold compound is able to fill the gap or cavity created through the protruding feature. It should be appreciated that die 102 may be any suitable integrated circuit, such as a microprocessor, programmable logic device, etc.

Figure 3 is a simplified schematic diagram illustrating a cross-sectional view of a package configuration for an integrated circuit in accordance with an alternate implementation for better understanding the invention. Package configuration 120 includes die 102 wire bonded to leads 104 of the lead frame through wires 112. Heat sink 108 is disposed in an offset manner from die paddle 106. As mentioned above, heat sink 108 may be dropped into the package configuration. Mold compound 110 is utilized to encapsulate die 102 and the lead frame. In one implementation mold compound 110 is provided through a transfer molding process. Die paddle 106 includes protruding features 130. Protruding features 130 extend from a surface of die paddle 106 opposing a surface of heat sink 108. In one implementation protruding features 130 extend from the surface of die paddle 106 between about 0.0127 cm and about 0.0254 cm. Consequently, a gap or cavity is created between a surface of heat sink 108 and die paddle 106, into which mold compound 110 is injected. It should be appreciated that the placement of the protruding features in Figures 2 and 3 is exemplary and not meant to be limiting. That is, the protruding features may be placed along an outer periphery of die paddle 106, a centrally located region of die paddle 106, or a combination of the two. In addition, the protruding features may be placed on a combination of heat sink 108 and die paddle 106. The same placement availability applies to protruding features of heat sink 108 also. One skilled in the art will appreciate that the materials of composition for the molding compound, the heat sink, and the lead frame may be any material utilized for IC packages.

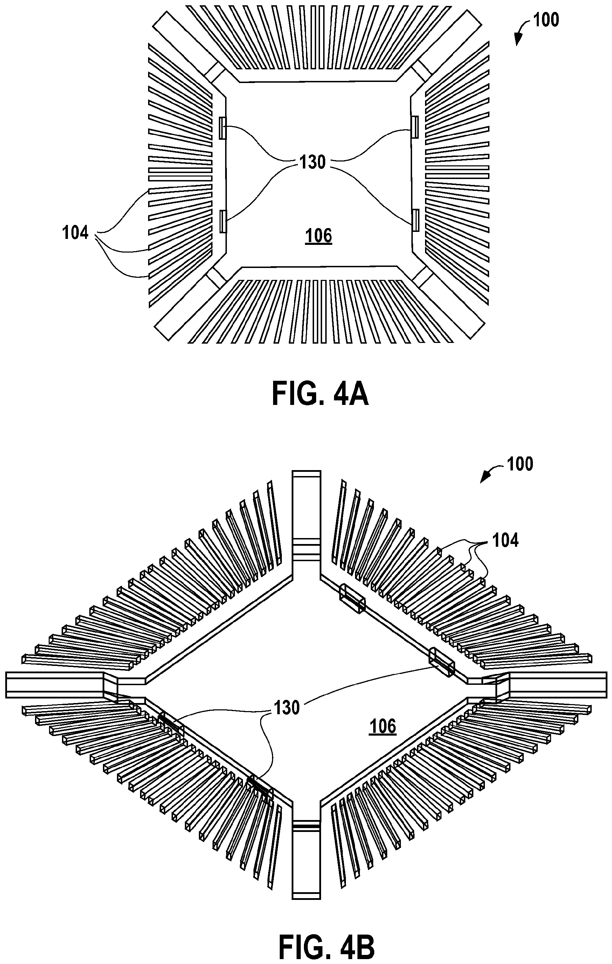

Figures 4A and 4B are simplified schematic diagrams illustrating alternate views of a lead frame having protruding features according to another example implementation useful for understanding better the invention. Figure 4A is a Top view, while Figure 4B is a top perspective view. Leads 104 extend from die paddle 106 of lead frame 100. Leads 104 may not be connected to the die paddle in. Protruding feature 130 is illustrated extending from the surface of die paddle 106. In this implementation, two pairs of protruding features 130 are illustrated extending from a peripheral region of opposing sides of die paddle 106. According to embodiments of the invention, a heat sink also has protruding features extending toward the die paddle surface and the heat sink's protruding features may mate with the lead frame of Figures 4A and 4B. As mentioned above, leads 104 and die paddle 106 may be oriented along different planes. This orientation may be accomplished through a stamping process.

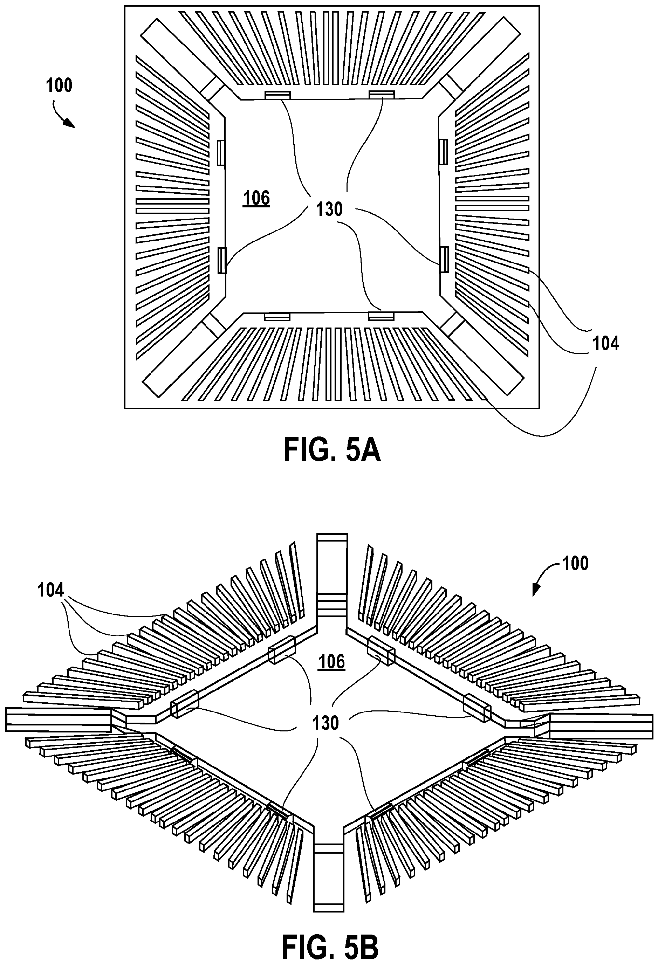

Figures 5A and 5B are simplified schematic diagrams illustrating alternate views of a lead frame having protruding features for an implementation varied from the implementation of Figures 4A and 4B. Figure 5A is a top view, while Figure 5B is a top perspective view. Leads 104 extend from die paddle 106 of lead frame 100. Protruding features 130 are illustrated extending from the surface of die paddle 106. In this implementation, four pairs of protruding features 130 are illustrated extending from a peripheral region of each of the sides of die paddle 106. One skilled in the art will appreciate that a heat sink having protruding features extending an equivalent amount from the surface of the heat sink toward different regions of the die paddle surface from where protruding features 130 extend may mate with the lead frame of Figures 5A and 5B, in one embodiment.

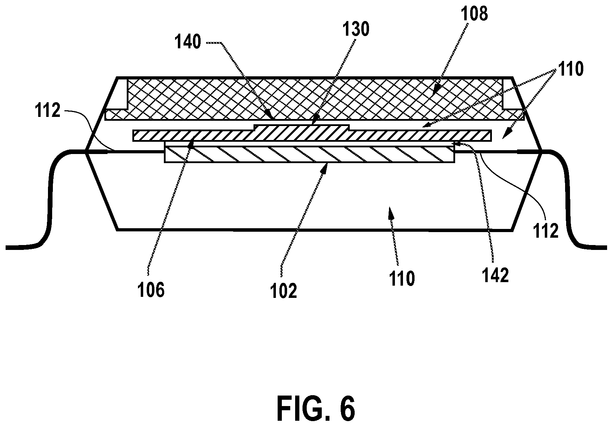

Figure 6 is a simplified schematic diagram illustrating a package configuration having a centrally located offset on a die paddle surface in accordance with an example implementation useful for a better understanding the invention. Die 102 is disposed onto a surface of die paddle 106. Die 102 is wire bonded to leads of the lead frame through wires 112. Die paddle 106 is configured to have a centrally located protrusion 130 extending from a surface of die paddle frame 106 that opposes the surface onto which die 102 is mounted. It should be appreciated that die 102 is affixed to the surface of die paddle 106 through epoxy 142. The centrally located protrusion 130 provides for a spaced apart configuration between a surface of heat sink 108 and die paddle 106. After dropping in heat sink 108 and upon transfer molding, mold compound 110 is able to penetrate into the gap created through the centrally located protrusion 130. That is, the spaced apart configuration between the surface of heat sink 108 and die paddle 106 is now filled with mold compound in order to provide enhanced structural integrity to the package. It should be appreciated that a relatively small area between centrally located protrusion 130 and the surface of heat sink 108 will preclude the mold compound 110 from penetrating. This area is represented by gap 140. However, since the surface of the centrally located protrusion against the heat sink is significantly reduced, the impact of any expansion forces becomes negligible.

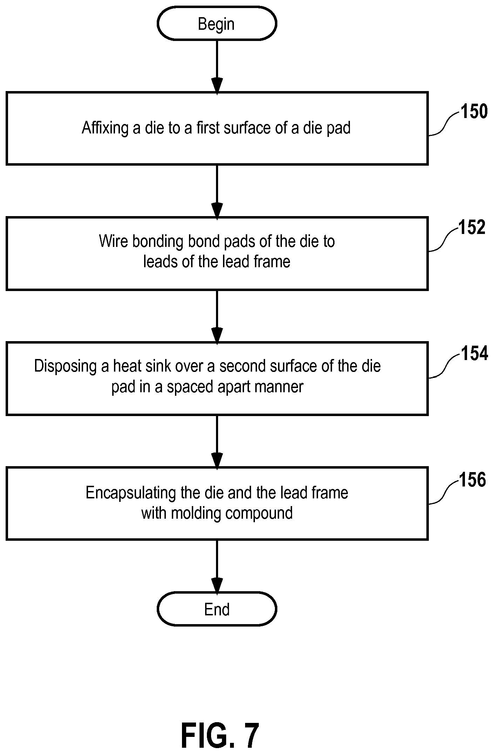

Figure 7 is a flowchart diagram illustrating the method operations of packaging a semiconductor device in accordance with one embodiment of the invention. The method initiates with operation 150 where a die is affixed to a first surface of the die pad. As noted above, the die may be affixed to the surface of the die paddle of the lead frame through epoxy. The method proceeds to operation 152 where the bond pads of the die are wire bonded to the leads of the lead frame. One skilled in the art will appreciate that any known technique for wire bonding may be utilized in this operation. The method advances to operation 154 where a heat sink is disposed over a second surface of the die paddle in a spaced apart manner. In operation 154 the heat sink may be dropped-into the package. As mentioned above, the heat sink may have protruding features that enable the spaced apart configuration illustrated in Figures 2, 3, and 6. Alternatively the die paddle, surface may have protrusions or protruding features extending therefrom. In addition, both the die pad surface and the heat sink may have the protruding features. The method then continues to operation 156 where the die and the lead frame are encapsulated with molding compound. It should be appreciated that the molding compound may be injected through a transfer molding procedure known in the art.

In summary, the embodiments provide for a package for an integrated circuit having a surface of the die pad and a surface of a heat sink spaced apart through protruding features in order to enable access of the molding compound between the heat sink and the die paddle. The presence of the molding compound in the gap created by the spaced apart configuration provides for enhanced structural integrity of the package, as opposed to the previous technique of dropping in the heat sink against the surface of the die pad and precluding molding compound between the surfaces. The molding compound utilized by the embodiments may be any suitable molding compounds known in the art, such as epoxy resins, etc.

The programmable logic device described herein may be part of a data processing system that includes one or more of the following components; ; memory; logic circuit; I/O circuitry; and peripheral devices. The data processing system can be used in a wide variety of applications, such as computer networking, data networking, instrumentation, video processing, digital signal processing, or any suitable other application where the advantage of using programmable or re-programmable logic is desirable. The programmable logic device can be used to perform a variety of different logic functions. For example, the programmable logic device can be configured as a processor or controller that works in cooperation with a system processor. The programmable logic device may also be used as an arbiter for arbitrating access to a shared resource in the data processing system. In yet another example, the programmable logic device can be configured as an interface between a processor and one of the other components in the system.

Any of the operations described herein that form part of the invention are useful machine operations. The invention also relates to a device or an apparatus for performing these operations. The apparatus can be specially constructed for the required purpose, or the apparatus can be a general-purpose computer selectively activated or configured by a computer program stored in the computer. In particular, various general-purpose machines can be used with computer programs written in accordance with the teachings herein, or it may be more convenient to construct a more specialized apparatus to perform the required operations.

As used herein programmable logic devices refer to any integrated circuit that may be programmed to perform a desired function and include programmable logic arrays (PLAs), programmable array logic (PAL), field programmable gate arrays (FPGA), complex programmable logic devices (CPLDs), and a wide variety of other logic and memory devices that may be programmed. Often, such PLDs are designed and programmed by a design engineer using an electronic design automation tool that takes the form of a software package.

## Claims

1. An integrated circuit package, comprising:
a lead frame (100);
a die (102) affixed to a first surface of a die paddle (106) of the lead frame (100), wherein the die (102) is wire bonded to leads (104) of the lead frame (100);
a heat sink (108) spaced apart from a second surface of the die paddle (106), the second surface opposing the first surface; and
a molding compound (110) encapsulating the lead frame (100) and the die (102), wherein a part of the molding compound (110) is disposed between the heat sink (108) and the second surface of the die paddle (106);
wherein the lead frame (100) has a plurality of protrusions (130) extending from the second surface of the die paddle (106) and the plurality of protrusions (130) space the heat sink (108) apart from a second surface of the die paddle (106);
**characterized in that**
the plurality of protrusions (130) extend from the second surface of the die paddle (106) along an outer periphery of the die paddle (106); and the heat sink (108) includes a plurality of protrusions (108a) extending from a surface of the heat sink (108) opposing the second surface of the die paddle (106).

2. The integrated circuit package of claim 1, wherein a plane of the first surface of the die paddle (106) is offset from a plane of the surface of the leads (104).

3. The integrated circuit of claim 1, wherein the first surface of the die paddle (106) is offset from a plane of the surface of the leads (104) and wherein an inner portion of the second surface of the die paddle (106) extends outward toward the heat sink (108).

4. The integrated circuit of claim 1, wherein a distance between a surface of the heat sink (108) and the second surface is between about 5 thousandths of an inch, i.e. 0.0127 cm, and about 10 thousandths of an inch, i.e. 0.0254 cm.

5. A method of packaging a semiconductor device, comprising:
affixing a die (102) to a first surface of a die paddle (106) of a lead frame (100);
wire bonding bond pads of the die (102) to leads (104) extending from the lead frame (100);
disposing a heat sink (108) over a second surface of the die paddle (106) and;
encapsulating the die (102) and the lead frame (100) with a molding compound such that the molding compound fills a cavity defined between the surface of the heat sink (108) and the portion of the second surface,
wherein the heat sink (108) is disposed over the second surface of the die paddle (106) such that a surface of the heat sink (108) is spaced apart from second surface of the die paddle (106) by protrusions (130)
**characterized in that**
the protrusions (130) extend from the second surface of the die paddle (106) along an outer periphery of the second surface of the die paddle (106), and the heat sink (108) includes protrusions (108a) extending from the surface of the heat sink (108).

6. The method of claim 5, wherein the second surface of the die paddle (106) further includes a centrally located protrusion extending therefrom.

7. The method of claim 5, wherein the cavity is between 0.0127 cm and 0.0254 cm.

8. The method of claim 5, wherein the leads (104) extending from the lead frame (100) are defined along a planar surface different than the first surface of the die paddle (106).

## Patentansprüche

1. Integrierter Schaltungsbaustein, umfassend:
einen Leiterrahmen (100);
einen Die (102), der an einer ersten Fläche einer Die-Kontaktstelle (106) des Leiterrahmens (100) befestigt ist, wobei der Die (102) an Leitungen (104) des Leiterrahmens (100) drahtgebondet ist;
eine Wärmesenke (108), die von einer zweiten Fläche der Die-Kontaktstelle (106) beabstandet ist, wobei die zweite Fläche der ersten Fläche gegenüberliegt; und
eine Formmasse (110), die den Leiterrahmen (100) und den Die (102) einkapselt, wobei ein Teil der Formmasse (110) zwischen der Wärmesenke (108) und der zweiten Fläche der Die-Kontaktstelle (106) angeordnet ist;
wobei der Leiterrahmen (100) eine Mehrzahl von Vorsprüngen (130) aufweist, die sich von der zweiten Fläche der Die-Kontaktstelle (106) erstreckt, und die Mehrzahl von Vorsprüngen (130) die Wärmesenke (108) von einer zweiten Fläche der Die-Kontaktstelle (106) beabstandet;
**dadurch gekennzeichnet, dass**
die Mehrzahl von Vorsprüngen (130) sich von der zweiten Fläche der Die-Kontaktstelle (106) entlang eines äußeren Umfangs der Die-Kontaktstelle (106) erstreckt; und die Wärmesenke (108) eine Mehrzahl von Vorsprüngen (108a) umfasst, die sich von einer Fläche der Wärmesenke (108) gegenüber der zweiten Fläche der Die-Kontaktstelle (106) erstreckt.

2. Integrierter Schaltungsbaustein nach Anspruch 1, wobei eine Ebene der ersten Fläche der Die-Kontaktstelle (106) von einer Ebene der Fläche der Leitungen (104) versetzt ist.

3. Integrierter Schaltungsbaustein nach Anspruch 1, wobei die erste Fläche der Die-Kontaktstelle (106) von einer Ebene der Fläche der Leitungen (104) versetzt ist, und wobei ein innerer Abschnitt der zweiten Fläche der Die-Kontaktstelle (106) sich in Richtung Wärmesenke (108) nach außen erstreckt.

4. Integrierter Schaltungsbaustein nach Anspruch 1, wobei ein Abstand zwischen einer Fläche der Wärmesenke (108) und der zweiten Fläche etwa 5 Tausendstel eines Zolls, d. h. 0,0127 cm, bis etwa 10 Tausendstel eines Zolls, d. h. 0,0254 cm, beträgt.

5. Verfahren zur Verkapselung eines Halbleiterbauelements, umfassend:
Befestigen eines Dies (102) an einer ersten Fläche einer Die-Kontaktstelle (106) eines Leiterrahmens (100) ;
Drahtbonden von Bondinseln des Dies (102) an Leitungen (104), die sich vom Leiterrahmen (100) erstrecken;
Anordnen einer Wärmesenke (108) über einer zweiten Fläche der Die-Kontaktstelle (106); und
Verkapseln des Dies (102) und des Leiterrahmens (100) mit einer Formmasse, derart dass die Formmasse einen Hohlraum ausfüllt, der zwischen der Fläche der Wärmesenke (108) und dem Abschnitt der zweiten Fläche definiert wird,
wobei die Wärmsenke (108) derart über der zweiten Fläche der Die-Kontaktstelle (106) angeordnet wird, dass eine Fläche der Wärmesenke (108) von der zweiten Fläche der Die-Kontaktstelle (106) durch Vorsprünge (130) beabstandet ist,
**dadurch gekennzeichnet, dass**
die Vorsprünge (130) sich von der zweiten Fläche der Die-Kontaktstelle (106) entlang eines äußeren Umfangs der zweiten Fläche der Die-Kontaktstelle (106) erstrecken, und die Wärmesenke (108) Vorsprünge (108a) umfasst, die sich von der Fläche der Wärmesenke (108) erstrecken.

6. Verfahren nach Anspruch 5, wobei die zweite Fläche der Die-Kontaktstelle (106) ferner einen mittig angeordneten Vorsprung umfasst, der sich davon erstreckt.

7. Verfahren nach Anspruch 5, wobei der Hohlraum zwischen 0,0127 cm und 0,0254 cm ist.

8. Verfahren nach Anspruch 5, wobei die Leitungen (104), die sich vom Leiterrahmen (100) erstrecken, entlang einer planaren Fläche definiert werden, die von der ersten Fläche der Die-Kontaktstelle (106) verschieden ist.

## Revendications

1. Boîtier de circuit intégré, comprenant :
une grille de connexion (100) ;
une puce (102) fixée à une première surface d'une plaque de support de puce (106) de la grille de connexion (100), la puce (102) étant connectée par fils à des fils de sortie (104) de la grille de connexion (100) ;
un dissipateur thermique (108) espacé d'une deuxième surface de la plaque de support de puce (106), la deuxième surface étant à l'opposé de la première surface ; et
un composé de moulage (110) encapsulant la grille de connexion (100) et la puce (102), une partie du composé de moulage (110) étant disposée entre le dissipateur thermique (108) et la deuxième surface de la plaque de support de puce (106) ;
dans lequel la grille de connexion (100) a une pluralité de saillies (130) s'étendant depuis la deuxième surface de la plaque de support de puce (106) et la pluralité de saillies (130) espacent le dissipateur thermique (108) d'une deuxième surface de la plaque de support de puce (106) ;
**caractérisé en ce que**
la pluralité de saillies (130) s'étendent depuis la deuxième surface de la plaque de support de puce (106) le long d'une périphérie externe de la plaque de support de puce (106) ; et le dissipateur thermique (108) comporte une pluralité de saillies (108a) s'étendant depuis une surface du dissipateur thermique (108) à l'opposé de la deuxième surface de la plaque de support de puce (106).

2. Boîtier de circuit intégré de la revendication 1, dans lequel un plan de la première surface de la plaque de support de puce (106) est décalé par rapport à un plan de la surface des fils de sortie (104).

3. Circuit intégré de la revendication 1, dans lequel la première surface de la plaque de support de puce (106) est décalée par rapport à un plan de la surface des fils de sortie (104) et dans lequel une partie interne de la deuxième surface de la plaque de support de puce (106) s'étend à l'extérieur vers le dissipateur thermique (108).

4. Circuit intégré de la revendication 1, dans lequel une distance entre une surface du dissipateur thermique (108) et la deuxième surface fait entre environ 5 millièmes de pouce, c.-à-d. 0,0127 cm, et environ 10 millièmes de pouce, c.-à-d. 0,0254 cm.

5. Procédé de mise en boîtier d'un dispositif semiconducteur, comprenant :
la fixation d'une puce (102) à une première surface d'une plaque de support de puce (106) d'une grille de connexion (100) ;
la connexion par fils de plots de connexion de la puce (102) à des fils de sortie (104) s'étendant depuis la grille de connexion (100) ;
la mise en place d'un dissipateur thermique (108) sur une deuxième surface de la plaque de support de puce (106) ; et
l' encapsulation de la puce (102) et de la grille de connexion (100) avec un composé de moulage de telle sorte que le composé de moulage remplisse une cavité définie entre la surface du dissipateur thermique (108) et la partie de la deuxième surface,
dans lequel le dissipateur thermique (108) est disposé sur la deuxième surface de la plaque de support de puce (106) de telle sorte qu'une surface du dissipateur thermique (108) est espacée de la deuxième surface de la plaque de support de puce (106) par des saillies (130),
**caractérisé en ce que**
les saillies (130) s'étendent depuis la deuxième surface de la plaque de support de puce (106) le long d'une périphérie externe de la deuxième surface de la plaque de support de puce (106), et le dissipateur thermique (108) comporte des saillies (108a) s'étendant depuis la surface du dissipateur thermique (108).

6. Procédé de la revendication 5, dans lequel la deuxième surface de la plaque de support de puce (106) comporte en outre une saillie située au centre s'étendant depuis celle-ci.

7. Procédé de la revendication 5, dans lequel la cavité fait entre 0,0127 cm et 0,0254 cm.

8. Procédé de la revendication 5, dans lequel les fils de sortie (104) s'étendant depuis la grille de connexion (100) sont définis le long d'une surface plane différente de la première surface de la plaque de support de puce (106).
